# EUROPEAN PATENT SPECIFICATION

(11) **EP 1 311 147 B1**
(45) Date of publication and mention of the grant of the patent: **17.11.2010**
(21) Application number: 02020348.5
(22) Date of filing: 12.09.2002
(51) Int. Cl.: H05K 7/20

(54) **Thermal conditioning method and equipment for electronic assembly shelters, with relative humidity control**
Verfahren zur thermischen Konditionierung und Ausstattung zur Unterbringung einer electronischen Anlagen mit Überwachung der relativen Feuchtigkeit
Méthode pour un conditionnement thermique et équipement abritant des installations électroniques, avec contrôle de l' humidité relative

(30) Priority: 17.09.2001 IT MI20011939
(43) Date of publication of application: 14.05.2003
(73) Proprietor: Siemens Mobile Communications S.p.A., 20126 Milano (IT)
(72) Inventor: Galas, Eric, 20161 Milano (IT); Polli, Roberto, 20066 Melzo (IT)
(74) Representative: Bruglachner, Thomas E.

(56) References cited:
- WO-A-98/10629
- DE-A1- 3 811 189
- US-A- 6 105 875

## Description

### Field of the invention

The present invention relates to shelters for electronic assemblies, in particular for telecommunications, and scope of the same is a method and equipment for the free cooling conditioning of said shelters, with relative humidity control of ventilation air.

### Background art

It is well known that electronic equipment, in particular those relating to telecommunication plants, must be maintained at adequate temperature to correctly operate. In the design of the equipment, an important aspect is therefore the dissipation of heat developed by the same. To this purpose, the different parts of an assembly are installed on supports or in shelters assuring high heat dissipations . The shelters destined to contain the complete equipment are then associated to thermal conditioning means.

Two solutions are usually foreseen for said thermal conditioning .

A first solution employs active (or closed circuit) air conditioning systems, whichever is the external temperature: in these systems, air coming from the shelters is cooled and is newly inlet when cooled. Examples of this system are described in JP-A-11083354 and JP-A-11135972. Being these systems always operating, they have high power consumption. Furthermore, they originate short-term temperature variations, tied to the transient of the thermal cycle, which decrease the average time between failures. This is an important aspect for the equipment and for base stations of mobile communication systems, mainly if placed in areas comparatively difficult to reach by the maintenance technicians or when far from service centres. In these systems no disadvantage is caused by humidity, since they operate in closed circuit.

DE 3811189 A1 shows a temperature/humidity control system for a switching cabinet where when a specific temperature (treq) is exceeded, the cooling device is switched on, and when the relative humidity exceeds a specific value, the cooling device is switched off or is not switched on, even if the signal which indicates that a specific temperature has been exceeded is present.

The second solution employs a free cooling (known as "free cooling"), according to which, air sucked from the external environment is inlet in the shelter, and hot air coming from the shelter is exhausted to the outside. An example is described in WO-A-9414308. Current free cooling systems are intrinsically free from short term variations, but are of poor effectiveness and show disadvantages due to the lack of a control on air humidity that, if too high, leads to corrosion phenomena of the above mentioned electronic assemblies.

### Object and summary of the invention

Object of the invention is to maintain the relative humidity value inside a shelter for electronic assemblies, conditioned through a free cooling system under a predetermined value.

According to a first aspect of the invention, it is offered a free cooling thermal conditioning method, in which a temperature desired value of air inside the shelter is set, and an external air flow-rate is conveyed to the assemblies (2), such to maintain the temperature of internal air at said desired value, **characterized in that** a desired value of the relative humidity of air inside the shelter is also set; a current value of said relative humidity is detected, it is compared with the humidity desired value and, if said current value exceeds said desired value, a positive correction of the internal air temperature desired value is made, bringing it from a basic value, used in conditions of relative humidity not higher than the desired value, to a new value matching which the relative humidity has humidity desired value .

According to another aspect of the invention an equipment is offered to implement the method, in which a control system acts on the means to convey and exhaust to the environment of ventilation air and/or recycle of air coming out from the assemblies in order that the assemblies are reached by ventilation air having characteristics such to maintain the internal air temperature at a desired value, **characterized in that** said control system includes also means to determine also the relative humidity of said internal air, compare it with a desired relative humidity value, stored in the control system, and, in case the desired relative humidity value is exceeded, perform a positive correction of the internal air temperature desired value, bringing it from a basic value, used in relative humidity conditions not higher than the desired value, to a new value matching which the relative humidity has said desired value.

### Brief description of figures

The present invention could be better understood considering the attached drawings showing a preferred embodiment of the invention, in which.
- Figure 1 represents a shelter for electronic assemblies incorporating air conditioning equipment according to the invention;
- Figure 2 shows a block diagram of the control system of the air conditioning equipment;
- Figures 3 and 4 are psychrometric diagrams explaining the operation of the invention; and
- Figure 5 shows a flow chart of the procedure according to the invention.

### Description of a preferred embodiment of the invention

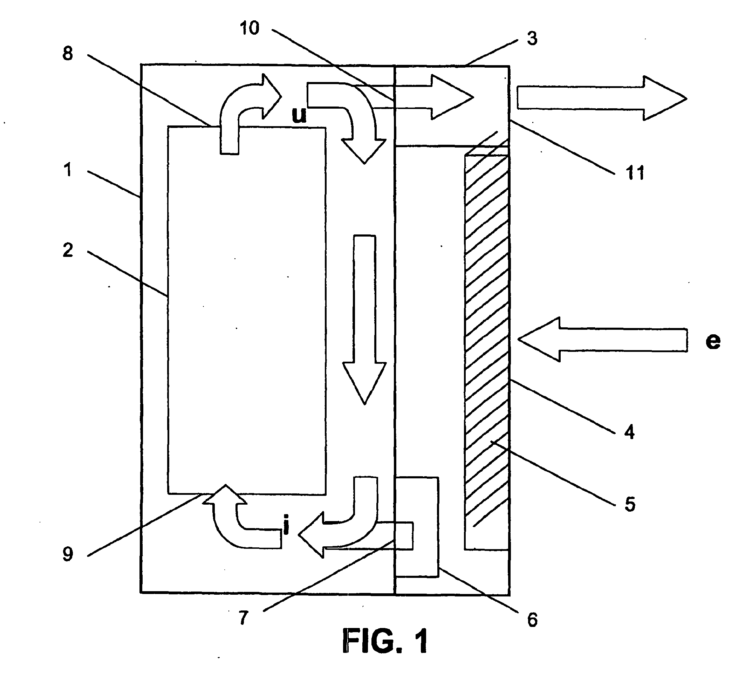

With reference to figure 1, a shelter 1 contains electronic assemblies 2 and the air free cooling conditioning system scope of the invention. This is housed in the structure of door 3 of the shelter. External air, in temperature and relative "e" (external) humidity conditions, enters the shelter from an opening 4, crossing a filter 5. Through a fan 6, external air is inlet in the shelter through an adjustable opening 7. In the lower part of the shelter 1, external air is mixed with air at the temperature and humidity "u" (assembly outlet) conditions coming from an outlet 8 of the assembly 2, reaching the "i" conditions (assembly inlet). Air in "i" conditions enters at the base of assemblies 9 and heats when crossing them, changing from "i" conditions to "u" conditions. A portion of the flow coming out from the assemblies is recycled and returns to the shelter base , as already said. The remaining portion enters the air conditioning system through an opening 10, which can be adjusted according to the regulation of opening 7, and is exhausted to the outside through opening 11.

The quantity of air recycled depends on the external air flow-rate that a control system determined to inlet in the shelter 1 based on temperature and humidity conditions. The control system, not shown in the figure, is housed in the shelter itself.

In particular, in conditions of high external temperature and low humidity, there will be great air change: openings 7 and 10 are in maximum opening condition, so that, in practice, all "u" air is exhausted while "i" air inlet in the equipment is made in practice only of external air. The high flow rates of external air requested in these conditions are made easy by the high dimensions of opening 4 that, as we can see, occupies the major part of the area of door 3 of the shelter 1.

In very low external temperature and high humidity conditions, openings 7 and 10 shall be closed and a total recycle shall be obtained: all the "u" air coming out from 8 re-enters 9, through the ventilation systems of the electronic assemblies. The closing of opening 10 prevents infiltration of humid air.

In intermediate conditions, we will have a mixing of "e" and "u" air in appropriate proportions to maintain temperature and relative humidity at pre-set SPₜ, SPᵤ values.

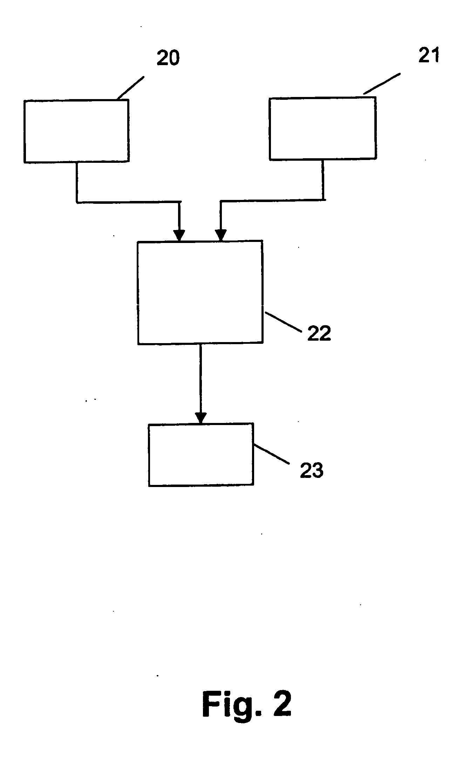

Figure 2 shows a block diagram of the control system. Temperature sensors 20 are foreseen to detect in particular the temperature Tᵢₙₜ of air at output 8 of the electronic assemblies 2, and relative humidity sensors 21, to detect in particular the relative humidity of air at inlet 9 of assemblies 2. The outputs of sensors 20, 21 are connected to a control logic unit 22, where the preset values SPₜ, SPᵤ for temperature and relative humidity and the appropriate correction programs are stored in case of deviation of the temperature and relative humidity from the pre-set values. Actuators 23, connected to appropriate control devices of openings 7 and 10, enable to adjust the inlet of external air and the recycle of air coming out from the assemblies based on the commands of the control unit 22.

The temperature control is managed by the regulation system in an essentially conventional way, through corrections on the flow rate of air entering through opening 7, increasing or decreasing it of a quantity proportional to the deviation from the pre-set value SPₜ. The correction to be made is defined starting from the difference Tᵢₙₜ-SPₜ, through a function depending on the type and calibration of the selected regulation, and therefore on the type of equipment in which the conditioning system is installed and on the climatic conditions in which it operates. The function is such not to generate instability in the regulated system.

Also the humidity control is governed by the regulation system on the basis of the difference Uₜₙ-SPᵤ, through appropriate correction functions. The corrections to maintain the desired humidity value act on the temperature value set SPₜ, which in turn controls the flow rate. The SPₜ value can be caused to vary between a basic value or minimum value SPₜ₀, which is the best temperature value preset on the basis of the system characteristics and of the average external climatic conditions, and a maximum value SPₜ₀+R, such to always assure an effective cooling of the assemblies.

In this way, if the relative humidity Uᵢₙₜ exceeds SPᵤ, the adequate increase of SPₜ it causes a decrease of the relative humidity that is newly brought to SPᵤ. If Uᵢₙₜ tends to drop, the system gradually brings SPₜ to lower values attempting to maintain U equal to SPᵤ, and this until SPₜ does not reach SPₜ₀. If U still drops, no other correction is made since SPₜ is already at its minimum SPₜ₀.

In the practice, damp hot environmental conditions such to excessively increase SPₜ are never recorded. In fact, as already known, the highest temperatures are reached in low relative humidity conditions. Analysis on climatic conditions to which telecommunication equipment installed in non-protected environment can be exposed have demonstrated that the highest temperature in matching 100% humidity is of approximately 31°C (see page 10 of ETS 300 019-1-4 standard, of ETSI European Telecommunication Standard Institute). Appropriately dimensioning the maximum flow rate, the consequent increase of SPₜ (tentatively 4-6°C in the worst conditions) is not critical for the correct cooling of the assemblies.

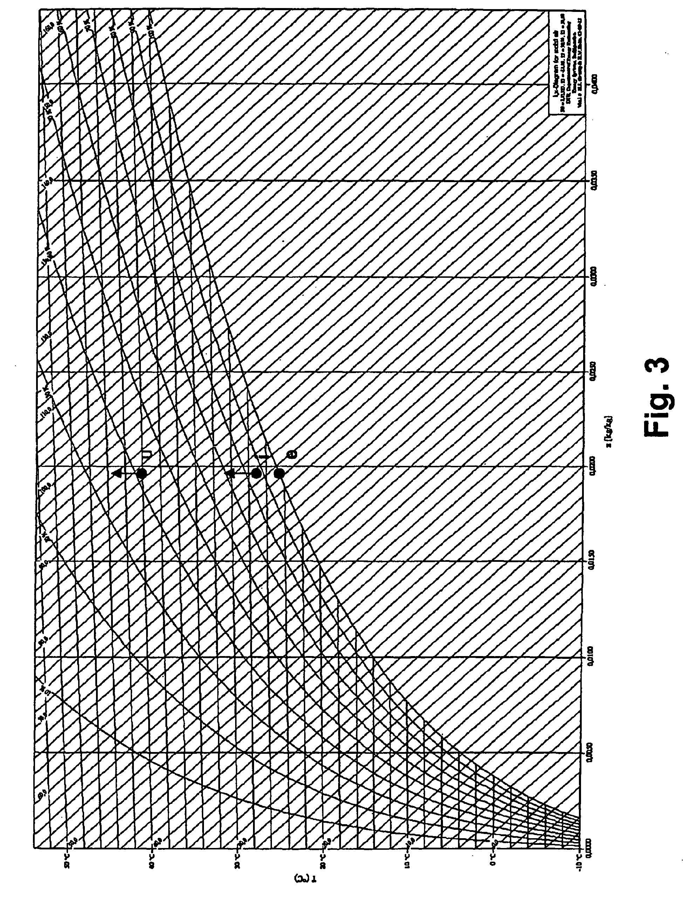

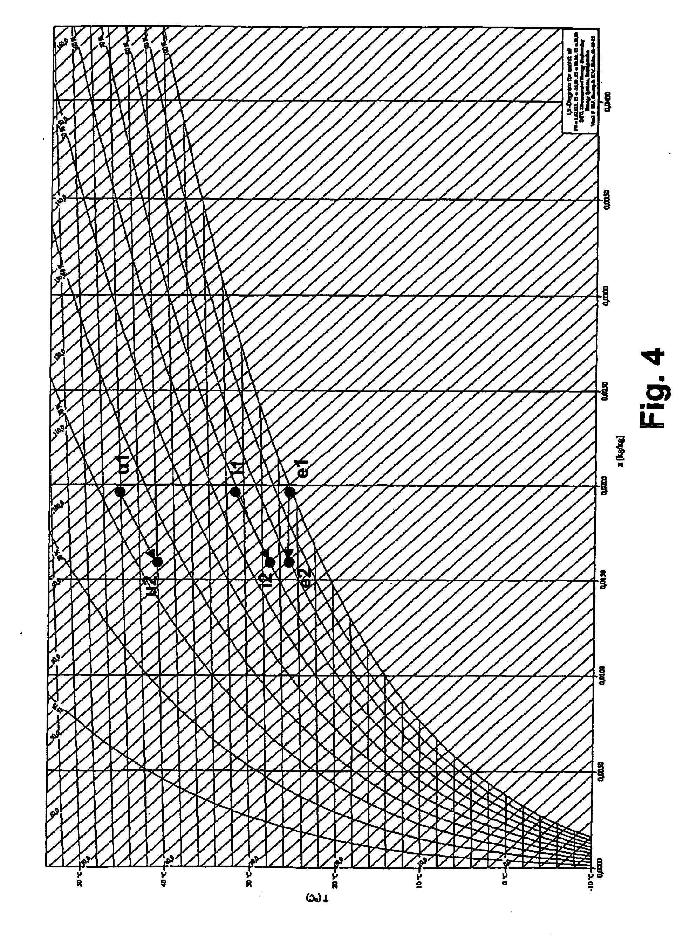

To better explain the invention, reference is made to psychrometric diagrams of figures 3 and 4. It is considered a free cooling system , without dehumidification, and therefore in these diagrams the three points "i", "e" and "u" (that is, the points representing the temperature and humidity conditions of external air, of air inlet in the assemblies and of air coming out from the same), are arranged on a straight line, since the absolute humidity (on the x-axis) remains constant. Also the vertical distance between point "i" and point "u" is constant, since it is set in the system design phase, based on the flow rate and power dissipated in the equipment.

For instance, in figures 3 and 4 it is considered a system with basic temperature value SPₜ₀ (u air temperature) of 40°C, a difference between "i" and "u" of 13°C (therefore "i" air at approx. 27°C), and a desired humidity SPᵤ value of 70%. It is assumed that external air "e" is approximately 25°C with a relative humidity of about 100%. The rate of external air contained in the flow crossing the assemblies is given by the ratio between the segments "i-u" and "e-u" and therefore the external air flow-rate is approx. 87%. Considered the absolute humidity of "e", "i" air has relative humidity of 90% approx., therefore higher than SPᵤ. As it can be clearly noticed in the diagram, as temperature increases, the relative humidity decreases, and therefore the situation is solved with an increase of SPₜ bringing "i" to the temperature in which the relative humidity is SPᵤ (approx. 31°C, point "i₁"). This is made bringing SPₜ to 44°C (point "u₁"), with a decrease of the external air flow rate down to approx. 69%.

Now, if the external air humidity decreases, reaching approximately 80% of relative humidity (see figure 4, point "e₂"), the internal air relative humidity can be maintained with lower temperature values. The system lowers SPₜ, bringing the temperature of air coming out from the assemblies to point "u₂" increasing the rate of external air: consequently "i" assumes "i₂" value. In particular, in fig. 4, it is assumed that SPₜ is newly brought to its basic value SPₜ₀ bringing external air to approximately 87%.

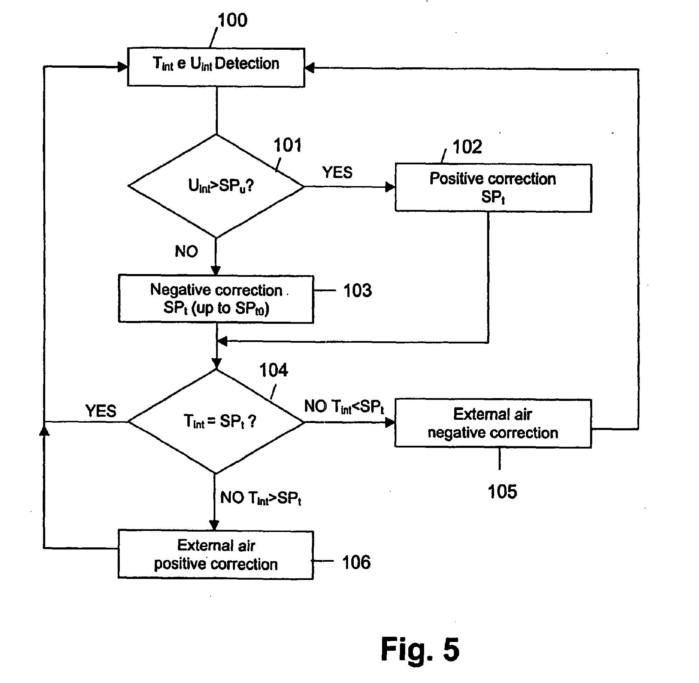

The humidity control described above is also shown in the flow chart of Fig. 5.

The first step 100 is the detection of the temperature and of the relative humidity Tᵢₙₜ, Uᵢₙₜ of internal air. The Uᵢₙₜ value is then compared with the preset value SPᵤ (step 101). Assuming the conditions of the example in figure 3, the comparison of step 101 indicates Uᵢₙₜ > SPᵤ and therefore the control unit 22 (fig. 2) sets for an increase of the SPₜ value (Positive correction SPₜ, step 102). The negative result of the control, which can lead to step 103 (Negative correction SPₜ up to SPₜ₀) shall be examined later on.

Assuming that the increase of SPₜ occurs by steps, e.g. of 1°C, the control unit compares (step 104) Tᵢₙₜ (40°C in the conditions of fig. 3) with the new SPₜ value (41°C). The comparison of step 104 indicates Tᵢₙₜ < SPₜ and therefore the control unit 22 controls, through actuators 23, a partial closing of opening 7 (Negative correction external air, step 105), and consequently of opening 10, in order to cause the increase of Tᵢₙₜ. At the new detection of Tᵢₙₜ and Uᵢₙₜ, after said correction, we still have Uᵢₙₜ > SPᵤ, so that and additional positive correction of SPt has to be made and consequently an additional negative correction of external air. The cycle proceeds until the SPt value is not reached, therefore Uᵢₙₜ = SPu (44°C approx. in the example). At this point, the control of step 101 gives negative result and the control unit actuates in a direction opposite to the previous one (negative correction of SPₜ), to bring SPₜ to SPₜ₀ value. The temperature control of step 104 indicates now Tᵢₙₜ > SPₜ, and therefore a positive correction of external air (step 106) shall be made. If at the next detection of Tᵢₙₜ, Uᵢₙₜ the humidity Uᵢₙₜ dropped under SPᵤ, as it can be seen for instance in fig. 4, the negative correction cycle of SPₜ and consequent positive correction of the external air continues until Uᵢₙₜ does not become again higher than SPᵤ or until Tᵢₙₜ does not reach SPₜ₀. In the first case, a new positive correction of SPₜ shall be made, while in the second case regulations are stopped.

As already said, the positive correction of SPₜ causes a maximum increase such to assure in any case an appropriate cooling of the assemblies, while the negative correction of SPₜ can never bring this value under the basic value SPₜ₀. In practice, this condition means that the control system does not perform any operation if the relative humidity is lower than SPᵤ, because in these conditions the air conditioning system maintains SPₜ at the basic value SPₜ₀. On the other hand, a low humidity of air, does not have in general any negative effect on the assemblies.

The operation logic is valid for any external condition, even the more severe one in terms of humidity (31°C at 100% relative humidity). The desired values for temperature and humidity, the air flow rate in the assemblies (and therefore the difference i-u), and the regulation and actuation system shall be selected in the most convenient way, keeping into account the assembly characteristics and the external climatic conditions. Of course, the system shall be calibrated in order not to cause intolerable width and frequency oscillations. This result is the normal practice of regulation systems design.

The essential advantage of the invention is to enable a free cooling while controlling the relative humidity, cause for disadvantages such as corrosion phenomena. Free cooling enables power consumption and construction cost savings, lacking the cooling plant. The relative humidity control based on the variation of working temperatures enables to give up to dehumidifiers, contributing to the reduced cost of the system. Also the filter does not require special materials and can be of the type used for normal household air conditioning devices, therefore low cost, in fact, considering the large area of opening 4, the pressure of external air is very low and there is no risk for rain droplet inlet. The intrinsic construction simplicity enables also an easy and economic maintenance compared to more complex plants with active air conditioning.

Therefore, while an embodiment of the present invention has been shown and described, it should be understood that other embodiments and/or additions thereto can be made by those skilled in the art. For instance, temperature and humidity controls could be made at points other than output 8 and input 9 of the equipment, respectively, the important thing is that the control unit 22 receives parameters enabling to determine the temperature and relative humidity of internal air. In the flow chart of figure 5, a negative correction of SPₜ only if Uᵢₙₜ < Spu could be made avoiding interventions when Uᵢₙₜ = SPu.

## Claims

1. Free cooling thermal air conditioning method for shelters (1) containing electronic assemblies (2), in which a desired value (SPₜ) of temperature (Tᵢₙₜ) of air inside the shelter (1) is set, and where an external air flow is conveyed to the assemblies, said air flow having a rate such as to maintain the internal air temperature (Tᵢₙₜ) at said desired value (SPₜ) is conveyed to the assemblies (2), **characterized in that** a desired value (SPᵤ) for the relative humidity of air inside the shelter (1) is set; the actual value (Uᵢₙₜ) of said relative humidity is determined, it is compared with the desired value (SPᵤ) and, if said actual value (Uᵢₙₜ) exceeds said desired value (SPᵤ), a positive correction of the desired value (SPₜ) of internal air temperature is made, bringing it from a basic value (SPₜ₀), employed in relative humidity conditions not higher than the desired value, to a new value (SPₜ₀+R) adapted to force the relative humidity to show said desired humidity value (SPᵤ).

2. Method according to claim 1, **characterized in that** said variation of the desired temperature value (SPₜ) is made varying the flow rate of external air mixed with air coming out from the equipment (2) and recycled to the same.

3. Method according to claim 1 or 2, **characterized in that** said desired value of relative humidity (SPᵤ) is a value lower than a dew point of a quantity such that said correction of the desired temperature value (SPₜ) is not higher than 4 - 6°C in the worst temperature and external air relative humidity conditions.

4. Method according to any of the previous claims, **characterized in that**, once reached said relative humidity desired value (SPᵤ), a negative correction of the temperature (SPₜ) desired value starts to bring it again to said basic value (SPₜ₀) as the relative humidity decreases.

5. Method according to claim 4, **characterized in that** said negative correction stops when said basic value (SPₜ₀) is reached.

6. Method according to any of the previous claims, **characterized in that** said corrections of the desired temperature value (SPₜ) are step corrections.

7. Method according to any of the previous claims, **characterized in that** the temperature and relative humidity desired values (SPₜ, SPᵤ) of internal air are temperature values of air coming out from the assemblies (2) and of the relative humidity of air sent to the assemblies (2), respectively.

8. Equipment for the free cooling thermal conditioning of shelters (1) containing electronic assemblies (2), in which a control system (20, 21, 22, 23), including means (20, 22) to determine temperature (Tᵢₙₜ) values of internal air of a shelter (1) to be conditioned, acts on means (4, 6, 7, 8, 9, 10, 11) for the conveyance to the assemblies (2) of ventilation air and to exhaust to the environment and/or recycle the air coming out from the assemblies (2) in order that ventilation equipment (2) are fed with air having characteristics such to maintain the temperature (Tᵢₙₜ) of internal air at a desired value (SPₜ), **characterized in that** said control system (20, 21, 22, 23) includes also means (21, 22) to determine the relative humidity (Uᵢₙₜ) of said internal air, comparing it with a relative humidity (SPᵤ) desired value, stored inside the control system (20, 21, 22, 23) and, in case the relative humidity desired value (SPᵤ) is exceeded, make a positive correction of the temperature desired value (SPₜ) bringing it from a basic value (SPₜ₀), employed in relative humidity conditions not higher than the desired value (SPᵤ), to a new higher value (max SPₜ₀+R) adapted to force the relative humidity to show said desired value (SPᵤ).

9. Equipment according to claim 8, **characterized in that** said control system (20, 21, 22, 23) is suitable to perform positive corrections of the desired value (SPₜ) of the internal air temperature in an interval (R), whose width does not exceed 4 - 6°C in the worst temperature and relative humidity conditions of external air.

10. Equipment according to claim 8 or 9, **characterized in that**, on restoration of the desired relative humidity (SPᵤ) value, said control system (20, 21, 22, 23) is suitable to make a negative correction of the desired temperature value, in order to bring the internal air temperature to the basic value (SPₜ₀).

11. Equipment according to claim. 10, **characterized in that** said control system (20, 21, 22, 23) is suitable to stop said negative correction of the desired temperature value (SPₜ) when basic value is reached (SPₜ₀).

12. Equipment according to any claim 8 through 10, **characterized in that** said control system (20, 21, 22, 23) is suitable to control step corrections of the desired temperature value .

13. Equipment according to any claim 8 through 11, **characterized in that** said conveyance means include an opening (8) fit with regulation means for sending adjustable flow rates of external air towards the assemblies (2) and for the recycle of flow rates of air coming out from the assemblies variable according to the flow rates of external air, and **in that** said control system (20, 21, 22, 23) includes devices (23) for the control of regulation means of said opening (8) to cause negative or positive correction of the external air flow rate such to originate said corrections of the desired temperature value.

14. Equipment according to any claim 8 to 13, **characterized in that** said temperature (Tᵢₙₜ) and relative humidity (Uᵢₙₜ) determination means of internal air include temperature sensors (20) adapted to detect the temperature of air coming out from the equipment (2) and humidity sensors (21) adapted to detect the relative humidity of air at the equipment inlet (2), respectively.

## Patentansprüche

1. Thermisches Klimatisierungsverfahren mit freier Kühlung für Schuppen (1), die elektronische Geräte (2) enthalten, wobei ein Sollwert (SPₜ) der Temperatur (Tᵢₙₜ) von Luft in dem Schuppen (1) gesetzt wird und eine äußere Luftströmung zu den Geräten befördert wird, wobei die Luftströmung, die eine Rate besitzt, derart, dass die Innenlufttemperatur (Tᵢₙₜ) auf dem Sollwert (SPₜ) gehalten wird, zu den Geräten (2) befördert wird, **dadurch gekennzeichnet, dass** ein Sollwert (SPᵤ) für die relative Feuchtigkeit von Luft in dem Schuppen (1) gesetzt wird; der Istwert (Uᵢₙₜ) der relativen Feuchtigkeit bestimmt wird, mit dem Sollwert (SPᵤ) verglichen wird und, falls der Istwert (Uᵢₙₜ) den Sollwert (SPᵤ) übersteigt, eine positive Korrektur des Sollwerts (SPₜ) der Innenlufttemperatur vorgenommen wird, wodurch er von einem Basiswert (SPₜ₀), der unter der Bedingung einer relativen Luftfeuchtigkeit, die nicht höher ist als der Sollwert, verwendet wird, auf einen neuen Wert (SPₜ₀ + R) gebracht wird, der geeignet ist, die relative Luftfeuchtigkeit dazu zu bringen, dass sie den Soll-Feuchtigkeitswert (SPᵤ) besitzt.

2. Verfahren nach Anspruch 1, **dadurch gekennzeichnet, dass** die Veränderung des Soll-Temperaturwerts (SPₜ) **dadurch** erfolgt, dass die Durchflussmenge von Außenluft, die mit der von der Anlage (2) kommenden Luft gemischt wird, verändert wird und dieser wieder zugeführt wird.

3. Verfahren nach Anspruch 1 oder 2, **dadurch gekennzeichnet, dass** der Sollwert der relativen Feuchtigkeit (SPᵤ) ein Wert ist, der niedriger als ein Taupunkt einer Menge ist, derart, dass die Korrektur des Soll-Temperaturwerts (SPₜ) unter schlechtesten Bedingungen für die Temperatur und die relative Feuchtigkeit der Außenluft nicht höher als 4-6 °C ist.

4. Verfahren nach einem der vorhergehenden Ansprüche, **dadurch gekennzeichnet, dass**, sobald der Sollwert (SPᵤ) für die relative Feuchtigkeit erreicht ist, eine negative Korrektur des Temperatursollwerts (SPₜ) beginnt, um sie wieder auf den Basiswert (SPₜ₀) zu bringen, wenn die relative Feuchtigkeit abnimmt.

5. Verfahren nach Anspruch 4, **dadurch gekennzeichnet, dass** die negative Korrektur endet, wenn der Basiswert (SPₜ₀) erreicht ist.

6. Verfahren nach einem der vorhergehenden Ansprüche, **dadurch gekennzeichnet, dass** die Korrekturen des Soll-Temperaturwerts (SPₜ) Stufenkorrekturen sind.

7. Verfahren nach einem der vorhergehenden Ansprüche, **dadurch gekennzeichnet, dass** die Sollwerte (SPₜ, SPᵤ) für die Temperatur bzw. die relative Feuchtigkeit der Innenluft Temperaturwerte von Luft, die von den Geräten (2) kommt, bzw. der relativen Feuchtigkeit von Luft, die zu den Geräten (2) geschickt wird, sind.

8. Anlage für die Klimatisierung mit freier Kühlung von Schuppen (1), die elektronische Geräte (2) enthalten, in der ein Steuersystem (20, 21, 22, 23), das Mittel (20, 22) zum Bestimmen der Temperaturwerte (Tᵢₙₜ) von Innenluft eines zu klimatisierenden Schuppens (1) enthält, auf Mittel (4, 6, 7, 8, 9, 10, 11) für die Versorgung der Geräte (2) mit Belüftungsluft und für die Abführung der von den Geräten (2) kommenden Luft an die Umgebung und/oder für deren Wiedergewinnung einwirkt, um die Entlüftungsanlage (2) mit Luft zu versorgen, die Eigenschaften besitzt, derart, dass die Temperatur (Tᵢₙₜ) der Innenluft auf einem Sollwert (SPₜ) gehalten wird, **dadurch gekennzeichnet, dass** das Steuersystem (20, 21, 22, 23) außerdem Mittel (21, 22) enthält, um die relative Feuchtigkeit (Uᵢₙₜ) der Innenluft zu bestimmen, sie mit einem Sollwert (SPᵤ) der relativen Feuchtigkeit zu vergleichen, der in dem Steuersystem (20, 21, 22, 23) gespeichert ist, und in dem Fall, in dem der Sollwert (SPᵤ) der relativen Feuchtigkeit überschritten wird, eine positive Korrektur des Temperatursollwerts (SPₜ) vorzunehmen, wodurch er von einem Basiswert (SPₜ₀), der unter einer Bedingung der relativen Feuchtigkeit verwendet wird, die nicht höher als der Sollwert (SPᵤ) ist, auf einen neuen höheren Wert (max SPₜ₀ + R) gebracht wird, der geeignet ist, die relative Feuchtigkeit dazu zu bringen, dass sie den Sollwert (SPᵤ) besitzt.

9. Anlage nach Anspruch 8, **dadurch gekennzeichnet, dass** das Steuersystem (20, 21, 22, 23) geeignet ist, positive Korrekturen an dem Sollwert (SPₜ) der Innenlufttemperatur in einem Intervall (R) vorzunehmen, dessen Breite unter schlechtesten Außenluftbedingungen für die Temperatur und für die relative Feuchtigkeit 4-6 °C nicht übersteigt.

10. Anlage nach Anspruch 8 oder 9, **dadurch gekennzeichnet, dass** das Steuersystem (20, 21, 22, 23) bei der Wiederherstellung des Sollwerts (SPᵤ) der relativen Feuchtigkeit eine negative Korrektur des Soll-Temperaturwerts ausführen kann, um die Innenlufttemperatur auf den Basiswert (SPₜ₀) zu bringen.

11. Anlage nach Anspruch 10, **dadurch gekennzeichnet, dass** das Steuersystem (20, 21, 22, 23) die negative Korrektur des Soll-Temperaturwerts (SPₜ) anhalten kann, wenn der Basiswert (SPₜ₀) erreicht ist.

12. Anlage nach einem der Ansprüche 8 bis 10, **dadurch gekennzeichnet, dass** das Steuersystem (20, 21, 22, 23) geeignet ist, Stufenkorrekturen des Soll-Temperaturwerts zu steuern.

13. Anlage nach einem der Ansprüche 8 bis 11, **dadurch gekennzeichnet, dass** die Beförderungsmittel eine Öffnung (8) aufweisen, die mit Regulierungsmitteln versehen ist, um einstellbare Durchflussmengen von Außenluft zu den Geräten (2) zu schicken und um Durchflussmengen von Luft, die von den Geräten kommen, variabel in Übereinstimmung mit den Durchflussmengen der Außenluft wiederzugewinnen, und dass das Steuersystem (20, 21, 22, 23) Vorrichtungen (23) enthält, um die Regulierungsmittel der Öffnung (8) so zu steuern, dass sie eine negative oder eine positive Korrektur an der Außenluft-Durchflussmenge hervorrufen, derart, dass die Korrekturen des Soll-Temperaturwerts vorgenommen werden.

14. Anlage nach einem der Ansprüche 8 bis 13, **dadurch gekennzeichnet, dass** die Mittel für die Bestimmung der Temperatur (Tᵢₙₜ) und der relativen Feuchtigkeit (Uᵢₙₜ) der Innenluft Temperatursensoren (20), die dazu ausgelegt sind, die Temperatur von Luft, die von der Anlage (2) kommt, zu detektieren, und Feuchtigkeitssensoren (21), die dazu ausgelegt sind, die relative Feuchtigkeit von Luft bei dem Anlageneinlass (2) zu detektieren, enthalten.

## Revendications

1. Procédé de conditionnement thermique d'air de refroidissement naturel pour des abris (1) contenant des ensembles électroniques (2), dans lequel une valeur désirée (SPₜ) de température (Tᵢₙₜ) de l'air à l'intérieur de l'abri (1) est fixée, et où un flux d'air extérieur est transporté jusqu'aux ensembles, ledit flux d'air ayant un débit tel que pour maintenir la température de l'air intérieur (Tᵢₙₜ) à ladite valeur désirée (SPₜ), **caractérisé en ce qu'**une valeur désirée (SPᵤ) pour l'humidité relative de l'air à l'intérieur de l'abri (1) est fixée ; la valeur réelle (Uᵢₙₜ) de ladite humidité relative est déterminée, elle est comparée à la valeur désirée (SPᵤ) et, si ladite valeur réelle (Uᵢₙₜ) excède ladite valeur désirée (SPᵤ), une correction positive de la valeur désirée (SPₜ) de la température de l'air intérieur est effectuée, l'amenant d'une valeur de base (SPₜ₀) employée dans des conditions d'humidité relative non supérieures à la valeur désirée, jusqu'à une nouvelle valeur (SPₜ₀+R) adaptée à forcer l'humidité relative à afficher ladite valeur d'humidité désirée (SPᵤ).

2. Procédé selon la revendication 1, **caractérisé en ce que** ladite variation de la valeur de température désirée (SPₜ) est effectuée en faisant varier le débit de l'air extérieur mélangé avec l'air sortant de l'équipement (2) et recyclé dans celui-ci.

3. Procédé selon la revendication 1 ou 2, **caractérisé en ce que** ladite valeur d'humidité relative désirée (SPᵤ) est une valeur inférieure à un point de rosée d'une quantité telle que ladite correction de la valeur de température désirée (SPₜ) n'est pas supérieure à 4 à 6°C dans les pires conditions de température et d'humidité relative de l'air extérieur.

4. Procédé selon l'une quelconque des revendications précédentes, **caractérisé en ce que**, une fois ladite valeur d'humidité relative désirée (SPᵤ) atteinte, une correction négative de la valeur désirée de température (SPₜ) commence à la ramener à ladite valeur de base (SPₜ₀) au fur et à mesure que l'humidité relative diminue.

5. Procédé selon la revendication 4, **caractérisé en ce que** ladite correction négative s'arrête lorsque ladite valeur de base (SPₜ₀) est atteinte.

6. Procédé selon l'une quelconque des revendications précédentes, **caractérisé en ce que** lesdites corrections de la valeur de température désirée (SPₜ) sont des corrections par pas.

7. Procédé selon l'une quelconque des revendications précédentes, **caractérisé en ce que** les valeurs désirées de température et d'humidité relative (SPₜ, SPᵤ) de l'air intérieur sont des valeurs de la température de l'air sortant des ensembles (2) et de l'humidité relative de l'air envoyé vers les ensembles (2), respectivement.

8. Équipement pour le conditionnement thermique par refroidissement naturel d'abris (1) contenant des ensembles électroniques (2), dans lequel un système de commande (20, 21, 22, 23), incluant un moyen (20, 22) pour déterminer des valeurs de température (Tᵢₙₜ) de l'air intérieur d'un abri (1) devant être conditionné, agit sur un moyen (4, 6, 7, 8, 9, 10, 11) pour le transport jusqu'aux ensembles (2) d'un air de ventilation et pour l'échappement dans l'environnement et/ou le recyclage de l'air sortant des ensembles (2) afin que l'équipement de ventilation (2) soit alimenté avec un air ayant des caractéristiques telles que pour maintenir la température (Tᵢₙₜ) de l'air intérieur à une valeur désirée (SPₜ), **caractérisé en ce que** ledit système de commande (20, 21, 22, 23) inclut également un moyen (21, 22) pour déterminer l'humidité relative (Uᵢₙₜ) dudit air intérieur, la comparer à une valeur désirée d'humidité relative (SPᵤ), stockée à l'intérieur du système de commande (20, 21, 22, 23) et, dans le cas où la valeur désirée d'humidité relative (SPᵤ) est dépassée, effectuer une correction positive de la valeur désirée de température (SPₜ) l'amenant d'une valeur de base (SPₜ₀) employée dans des conditions d'humidité relative non supérieures à la valeur désirée (SPᵤ), jusqu'à une nouvelle valeur supérieure (SPₜ₀+R) adaptée à forcer l'humidité relative à afficher ladite valeur désirée (SPᵤ).

9. Équipement selon la revendication 8, **caractérisé en ce que** ledit système de commande (20, 21, 22, 23) est approprié pour effectuer des corrections positives de la valeur désirée (SPₜ) de la température de l'air intérieur dans un intervalle (R), dont la largeur n'excède pas 4 à 6°C dans les pires conditions de température et d'humidité relative de l'air extérieur.

10. Équipement selon la revendication 8 ou 9, **caractérisé en ce que**, à la restauration de la valeur désirée d'humidité relative (SPᵤ), ledit système de commande (20, 21, 22, 23) est approprié à effectuer une correction négative de la valeur désirée de température, afin d'amener la température de l'air intérieur jusqu'à la valeur de base (SPₜ₀).

11. Équipement selon la revendication 10, **caractérisé en ce que** ledit système de commande (20, 21, 22, 23) est approprié à stopper ladite correction négative de la valeur désirée de température (SPₜ) lorsque la valeur de base (SPₜ₀) est atteinte.

12. Équipement selon l'une quelconque des revendications 8 à 10, **caractérisé en ce que** ledit système de commande (20, 21, 22, 23) est approprié à commander des corrections par pas de la valeur désirée de température.

13. Équipement selon l'une quelconque des revendications 8 à 11, **caractérisé en ce que** ledit moyen de transport inclut une ouverture (8) équipée d'un moyen de régulation pour envoyer des débits ajustables d'air extérieur vers les ensembles (2) et pour le recyclage de débits d'air sortant des ensembles variables en fonction des débits d'air extérieur, et **en ce que** ledit système de commande (20, 21, 22, 23) inclut des dispositifs (23) pour la commande du moyen de régulation de ladite ouverture (8) pour causer une correction négative ou positive du débit d'air extérieur, de façon à commencer lesdites corrections de la valeur désirée de température.

14. Équipement selon l'une quelconque des revendications 8 à 13, **caractérisé en ce que** ledit moyen de détermination de température (Tᵢₙₜ) et d'humidité relative (Uᵢₙₜ) de l'air intérieur inclut des capteurs de température (20) adaptés à détecter la température de l'air sortant de l'équipement (2) et des capteurs d'humidité (21) adaptés à détecter l'humidité relative de l'air à l'entrée de l'équipement (2), respectivement.
